# EUROPEAN PATENT SPECIFICATION

(11) **EP 2 884 212 B1**
(45) Date of publication and mention of the grant of the patent: **06.06.2018**
(21) Application number: 13197175.6
(22) Date of filing: 13.12.2013
(51) Int. Cl.: F28F 3/08, F28F 3/10, C23C 16/06, C23C 16/56, F28D 9/00

(54) **Method for producing a plate heat exchanger and plate heat exchanger**
Verfahren zur Herstellung eines Plattenwärmetauschers und Plattenwärmetauscher
Procédé pour la production d'un échangeur de chaleur à plaques et échangeur de chaleur à plaques

(43) Date of publication of application: 17.06.2015
(73) Proprietor: Alfa Laval Corporate AB, 221 00 Lund (SE)
(72) Inventor: Bergh, Jesper, SE-237 41 Bjärred (SE); Nilsson, Maribel, SE-374 30 Karlshamn (SE); Nilsson, Mats, SE-226 47 Lund (SE)
(74) Representative: Alfa Laval Attorneys

(56) References cited:
- WO-A1-2004/011868
- WO-A2-2011/159238
- US-A1- 2011 011 571

## Description

### Technical Field

The invention relates to a method for producing a plate heat exchanger according to the preamble of claim 1.

The invention also relates to a plate heat exchanger produced according to the method.

### Background

Plate heat exchangers provided with gaskets normally comprise a package of heat exchanger plates arranged adjacent to one another. Gaskets are disposed between the heat exchanger plates, or the plates may also be permanently joined together in pairs to form so-called cassettes, e.g. by welding, with gaskets placed between the respective cassettes. The gaskets are accommodated in gasket grooves formed during the form-pressing of the heat exchanger plates. Plate heat exchangers further comprise inlet and outlet ports, which extend through the plate package, for two or more media.

Heat exchanger plates are normally made by form-pressing of sheet metal and are arranged in the plate package in such a way as to form first plate intermediate spaces which communicate with the first inlet port and the first outlet port, and second plate intermediate spaces which communicate with the second inlet port and the second outlet port. The first and second plate intermediate spaces are disposed alternately in the plate package.

A heat exchanger plate for a plate heat exchanger normally includes a heat transfer area and a border area, which is located outside the heat transfer area and which extends along and delimits the heat transfer area. Such a heat exchanger plate further has a number of open portholes. The heat exchanger plates are kept together to a plate package by means of tie bolts.

The gaskets, which are used between the heat exchanger plates in the plate heat exchanger, are manufactured separately, for instance by compression moulding or injection moulding. The gaskets are usually manufactured in any relatively hard rubber material such as nitrile; EFDM or fluorine rubber. The gasket may be attached to the heat exchanger plate by gluing. The gasket may also include various guide members, for instance so called T-tabs, which extend outwardly from the gasket and which are pressed to attachment in corresponding grooves in the heat exchanger plate.

The plates of heat exchangers are predominantly made of metal sheets. Depending on the nature of the media that are to be used in the plate heat exchanger the quality of the metal may vary. If highly corrosive media are to be used the requirements on corrosion resistance are high. Today the choice is often between materials which may corrode giving a short life time of the plate heat exchanger with a risk of contaminating the fluid or a heat exchanger made of a more corrosion resistant material, the latter being very expensive in comparison.

Tantalum is a very corrosion resistant metal towards many fluids and it is known to make heat exchangers of this metal. However, tantalum is an expensive metal and is mechanically considerably weaker than other known materials for use in heat exchangers such as stainless steel. Thus, often thicker plates must be used to withstand the mechanical stress put on a heat exchanger made of tantalum which further adds to the costs.

One method of lowering the costs and still benefit from the high corrosion resistance properties of tantalum is to apply a layer of a tantalum containing coating on a cheaper base material, such as stainless steel and carbon steel.

In utility model No DE 8310039 (U1) a plate heat exchanger is described wherein the plates are made of a cheap base material and a covering layer of a corrosion resistant material is applied, such as titanium or tantalum.

WO 2011/159238 discloses a method for the application of a solid film of a tantalum containing coating onto surfaces within a permanently joined plate package or plate heat exchanger in order to achieve good mechanical properties and high corrosion resistance of all parts the permanently joined plate heat exchanger. Tantalum nitride is mentioned as one example of a tantalum containing coating. WO 2004/011868 A1 discloses a method for producing a plate heat exchanger comprising gaskets and gasket grooves. However, it would be desirable to find new ways to ensure more corrosion resistant heat exchangers in order to be able to process highly corrosive media and increase the life time of the heat exchangers. It is also desirable to be able to produce corrosion resistant heat exchangers from cheaper base materials that have good mechanical properties and are easily and effectively assembled. Furthermore, it would be desirable that all parts of a heat exchanger, e.g. both plates and joints, which are in contact with a highly corrosive fluid are equally highly corrosion resistant. Further, it would be desirable to achieve more fatigue and corrosion resistant internal parts of heat exchangers in contact with highly corrosive fluids. It would also be desirable to find corrosion and fatigue resistant materials applied on the inside of a plate heat exchanger, which materials show good adhesion.

However, a problem encountered with the previously known plate heat exchangers coated with tantalum is the low abrasion and wear resistance of the tantalum coating. This eventually results in that the tantalum anticorrosion coating is wore off, especially at the contact points between two plates in a plate package. Needless to say, once the coating no longer covers the base metal corrosion proceeds rapidly and the corroded plates must be replaced.

### Summary

It is an object of the present invention to provide a plate heat exchanger which, at least partly, eliminate potential limitations of the prior art.

This object has been achieved by a method for producing a plate heat exchanger according to the preamble of claim 1 characterized in that the heat exchanger plates are at least partially coated by a tantalum containing compound and, after the coating, said plates are treated in a gas atmosphere containing nitrides chosen from amides at a temperature of 850-950 °C in order to increase the hardness and wear resistance of the tantalum surface to a surface hardness of > 600 HV.

By this method a more corrosion resistant plate heat exchanger is achieved which makes it possible to process highly corrosive media and increase the life time of the heat exchanger. Furthermore, the method may provide corrosion resistant heat exchangers made from cheaper base materials that have good mechanical properties. Due to the method all parts of the heat exchanger, e.g. both plates and joints, which are in contact with a highly corrosive fluid are equally highly corrosion resistant, and has high abrasion and wear resistance. Further, more fatigue and corrosion resistant internal parts of heat exchangers in contact with highly corrosive fluids are achieved and at the same time a high abrasion and wear resistance is obtained. The latter is especially valuable in the contact points between two adjacent plates in the plate package.

According to one embodiment of the invention the plates are treated by nitrides chosen from amides at a temperature of 900°C.

According to another embodiment of the invention the nitrides are chosen from amides such as urea, acetamide and formamide.

According to another embodiment of the invention the coating has a surface hardness of > 1000 HV.

The invention also relates to a plate heat exchanger produced according to the method.

With the present invention simple rigid base materials for heat exchangers such as stainless steel and carbon steel can be used and with a tantalum containing coating be made corrosion resistant to highly corrosive fluids and still avoid the previous problems of low abrasion resistance and wear resistance, especially in the contact points between two adjacent plates.

### Brief Description of the Drawings

The invention will now be described in more detail with reference to the appended schematic drawings, in which
Fig. 1 discloses schematically a side view of a plate heat exchanger.
Fig. 2 discloses schematically a plan view of the plate heat exchanger in Fig 1.
Fig. 3 discloses schematically a heat exchanger plate of the plate heat exchanger in Fig 1.
Fig. 4 discloses the heat exchanger plate in Fig 3 with gaskets provided.

### Detailed description of Embofiments of the invention

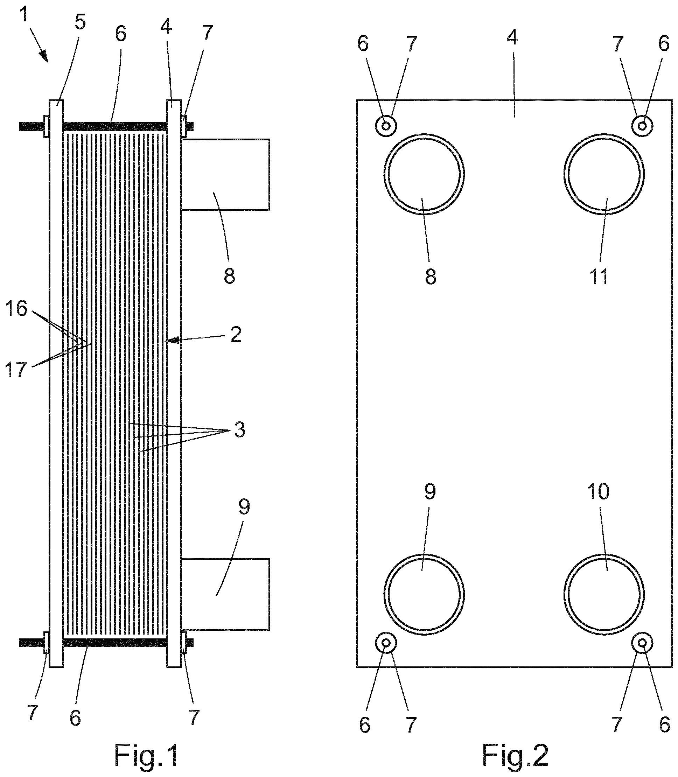

Figs 1 and 2 disclose a plate heat exchanger 1 comprising a plate package 2 having heat exchanger plates 3 which are provided beside each other. The plate package 2 is provided between two end plates 4 and 5 which may form a frame plate and a pressure plate, respectively. The end plates 4 and 5 are pressed against the plate package 2 and against each other by means of tie bolts 6 which extend through the end plates 4 and 5. The tie bolts 6 comprise threads and the plate package 2 may thus be compressed by screwing nuts 7 on the tie bolts 6 in a manner known per se. In the embodiment disclosed, four tie bolts 6 are indicated. It is to be noted that the number of tie bolts 6 may vary and be different in different applications.

The plate heat exchanger 1 comprises according to the embodiments described also a first inlet port 8 and a first outlet port 9 for a first medium, and a second inlet port 10 and a second outlet port 11 for a second medium. The inlet and outlet ports 8-11 extend in the embodiments disclosed through one of the end plates 4 and the plate package 2. The ports 8-11 may be arranged in many different ways and also through the second end plate 5.

The heat exchanger plates 3 may be manufactured in a compression- moulded metal sheet, carbon steel, stainless steel, or any other material which is suitable for the intended application.

Each heat exchanger plate 3 comprises a heat transfer area 12 and an edge area 13, which extends around and outside the heat transfer area 12. The heat transfer area 12 is in the embodiment disclosed substantially centrally located on the heat exchanger plate 3, and in a known manner provided with a corrugation 14 of ridges and valleys. The corrugation 14 is obtained through compression-moulding of the metal sheet. In the embodiment disclosed, the corrugation 14 has merely been indicated schematically as extending obliquely over the heat transfer area 12. It is to be noted that the corrugation 14 also may comprise significantly more complicated extensions of the ridges and valleys, for instance along the fishbone pattern known per se. Also heat exchanger plates 3 having a substantially plane heat transfer area may be used within the scope of this invention.

Each heat exchanger plate 3 also comprises a number of portholes 15, in the embodiment disclosed four portholes 15, which extend through the heat exchanger plate 3 and are located inside and in the proximity of the edge area 13. The portholes 15 are located in the proximity a respective corner of the heat exchanger plate 3 and are substantially concentric with the above mentioned inlet and outlet ports 8-11 of the plate heat exchanger 1.

The heat exchanger plates 3 are provided in such a manner in the plate package 2 that first plate interspaces 16, which communicate with the first inlet port 8 and the first outlet port 9, and second plate interspaces 17, which communicate with the second inlet port 10 and the second outlet port 11, are formed, see figs. 1 and 6. The first and second plate interspaces 16 and 17 are provided in an alternating order in the plate package 2.

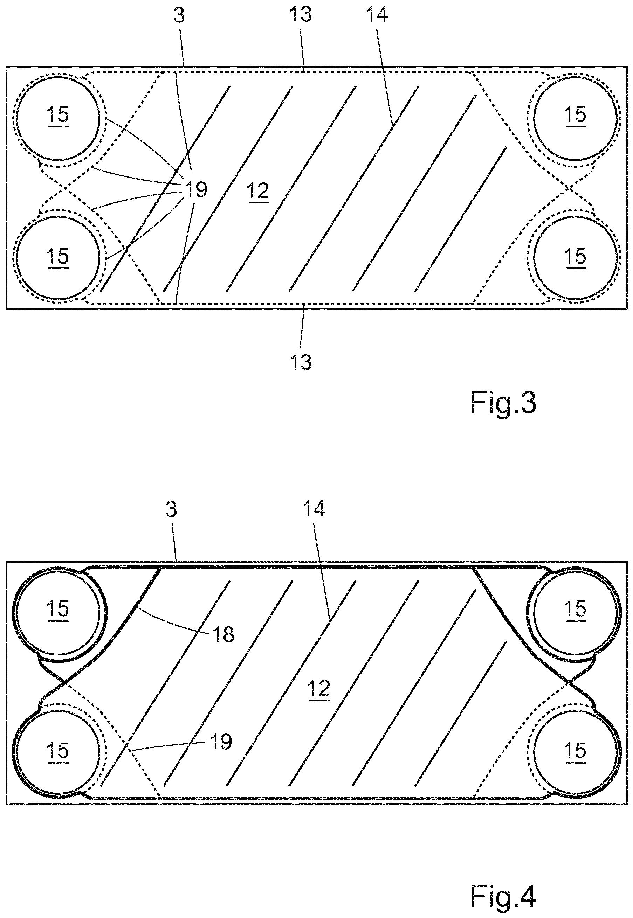

Such a separation of the plate interspaces 16, 17 may be achieved by means of one or several gaskets 18, which extend in the gasket grooves 19 which are formed during the compression-moulding of the heat exchanger plates 3. The gasket groove 19 of each heat exchanger plate 3 extends, as can be seen in fig. 3, around the heat transfer area 15 and around each of the portholes 15. At each heat exchanger plate 3 a gasket 18 is, in the embodiments disclosed, provided before the mounting of the plate heat exchanger 1. The gasket 18 extends in a part of the gasket groove 19 in such a way that the gasket 18 encloses the heat transfer area 12 and two of the portholes 15 and also each of the two remaining portholes 15. The gasket 18 thus forms three separate areas which are delimited from each other by means of the gasket 18. It is to be noted that the gasket 18 does not necessarily need to be shaped as one single gasket 18 but may also consist of several different gaskets.

During the mounting, every second heat exchanger plate 3 may be rotated 180°, for instance around a central normal axis or round a central longitudinal axis. Thereafter the heat exchanger plates 3 are compressed so that the desired first and second plate interspaces are obtained. In the plate package 2, the first medium may be introduced through the first inlet port 8, through the first plate interspaces 16 and out through the first outlet port 9. The second medium may be introduced through the second inlet port 10, through the second plate interspaces 17 and out through the second outlet port 11. The two media may for instance be conveyed in a counter current flow, as indicated in figs. 2 and 3, or in parallel flow in relation to each other.

In the embodiments described, the portholes 15 have a cylindrical or substantially circular shape. The portholes 15 may however also have any other suitable regular or irregular shape, for instance an oval shape or a polygonal shape, for instance a triangular, a square, a pentagonal etc. shape suitably with somewhat rounded corners.

The heat exchanger plate 3 may be used in various plate heat exchanger applications and include fewer or more than the portholes 15 disclosed. Furthermore, the invention is applicable to plate heat exchangers without portholes 15, wherein the inlet members and the outlet members may connect to different sides of the plate package.

According to the invention a plate for a plate heat exchanger as described above is coated with a tantalum containing compound preferably metal tantalum, tantalum oxide and/or tantalum nitride, which is applied on the surfaces of the heat exchanger plates 3 to be in contact with highly corrosive fluid. In a preferred embodiment the tantalum containing compound is metal tantalum and/or tantalum oxide, preferably metal tantalum. If the tantalum coating is made of metal tantalum the uppermost part of the coating is oxidized and thus is tantalum oxide.

The coating may according to the invention preferably be applied by means of Chemical Vapor Deposition (CVD). A basic CVD process may consist of the following steps: 1) a predefined mix of reactant gases and diluent inert gases are introduced at a specified flow rate into the reaction chamber; 2) the gas species move to the substrate; 3) the reactants get adsorbed on the surface of the substrate; 4) the reactants undergo chemical reactions with the substrate to form the film; and 5) the gaseous by-products of the reactions are desorbed and evacuated from the reaction chamber.

According to the present invention the tantalum containing coating applied onto the surfaces in at least one of the flow sides designated for being used for highly corrosive fluids has preferably a film thickness of about 1-125 µm, preferably 1-50 µm, more preferably 10-40 µm and even more preferably 15-25 µm.

Thermo-chemical surface treatments of iron and steel by means of nitrogen or carbon carrying gases are known processes, called nitriding or carburizing, respectively. Nitrocarburizing is a process in which a gas carrying both carbon and nitrogen is used. These processes are traditionally applied to improve the hardness and wear resistance of iron and low alloyed steel articles. The steel article is exposed to a carbon and/or nitrogen carrying gas at an elevated temperature for a period of time, whereby the gas decomposes and carbon and/or nitrogen atoms diffuse through the steel surface into the steel material. The outermost material close to the surface is transformed into a layer with improved hardness, and the thickness of this layer depends on the treatment temperature, the treatment time and the composition of the gas mixture.

According to the present invention the plates 3, after the coating by a tantalum containing compound, are treated in a nitrogen containing gas atmosphere at a temperature of approximately 850- 950 °C, and most preferably at a temperature 900 °C, for about an hour. The nitrogen containing gas is chosen from nitrides chosen from amides, especially amides such as urea, acetamide and formamide

Before the treatment the hardness of the tantalum containing layer was measured to approximately 300 HV by means of e g a hardnessmeter. After the nitrogen containing gas treatment, the surface hardness of the tantalum containing layer was measured to approximately 1500 HV. The hardness of the tantalum containing layer at a distance of approximately 2 µm from the surface was measured to a value of approximately 600 HV. According to the invention the hardness of the plates is preferably > 1000 HV.

By the method of the invention a corrosion resistant plate heat exchanger is achieved which is cheaper to manufacture and has a longer life time than previously known tantalum coated plate heat exchangers. Due to the hardening of the tantalum containing coating, the abrasion resistance and the wear resistance of the coating is increased, which is especially valuable in the contact points between the plates.

The invention is not limited to the described embodiments but may be varied and modified within the scope of the following claims.

## Claims

1. Method for producing a plate heat exchanger (1) comprising a plurality of heat exchanger plates (3), wherein the heat exchanger plates (3) are provided adjacent each other and form a plate package (2) with first plate interspaces (16) for a first medium and second plate interspaces (17) for a second medium, wherein each of the heat exchanger plates comprises
portholes (15) which form ports (8, 9, 10, 11) extending through the plate package (2),
a heat transfer area (12),
an edge area (13) extending outside the heat transfer area (12) and the ports (8, 9, 10, 11),
a gasket groove (19) extending in the edge area (13) outside the heat transfer area (12) and the ports (8, 9, 10, 11),
and wherein a gasket (18) is provided in the gasket groove (19) for tight abutment against an adjacent plate (3) in the plate heat exchanger (1),
**characterized in that** the heat exchanger plates (3) are at least partially coated with a tantalum containing compound and, after said coating, the plates (3) are treated in a gas atmosphere containing nitrides chosen from amides at a temperature of 850 - 950 °C in order to increase the hardness and wear resistance of the tantalum surface to a surface hardness of > 600 HV.

2. Method for producing a plate heat exchanger according to claim 1,
**characterized in that** the plates (3) are treated by nitrides chosen from amides at a temperature of 900 °C.

3. Method for producing a plate heat exchanger according to claim 1 or 2,
**characterized in that** the nitrides are chosen from amides such as urea, acetamide and formamide.

4. Method for producing a plate heat exchanger according claim 1,
**characterized in that** the coating has a surface hardness of > 1000 HV.

5. A plate heat exchanger produced according to the method of any one of claims 1-4.

## Patentansprüche

1. Verfahren zur Herstellung eines Plattenwärmetauschers (1), umfassend eine Vielzahl von Wärmetauscherplatten (3), wobei die Wärmetauscherplatten (3) angrenzend aneinander bereitgestellt werden und eine Plattenpackung (2) bilden mit ersten Platten-Zwischenräumen (16) für ein erstes Medium und zweiten Platten-Zwischenräumen (17) für ein zweites Medium, wobei jede der Wärmetauscherplatten Folgendes umfasst:
Anschlussöffnungen (15) zum Bilden von Anschlüssen (8, 9, 10, 11), welche sich durch die Plattenpackung (2) erstrecken,
eine Wärmeübertragungsfläche (12),
eine Kantenfläche (13), welche sich außerhalb der Wärmeübertragungsfläche (12) und der Anschlüsse (8, 9, 10, 11) erstreckt,
eine Dichtungsrille (19), welche sich in die Kantenfläche (13) außerhalb der Wärmeübertragungsfläche (12) und der Anschlüsse (8, 9, 10, 11) erstreckt,
und wobei eine Dichtung (18) in der Dichtungsrille (19) zum dichten Anschlagen gegen eine angrenzende Platte (3) im Plattenwärmetauscher (1) bereitgestellt ist, **dadurch gekennzeichnet, dass**:
die Wärmetauscherplatten (3) mindestens teilweise mit einer tantalhaltigen Verbindung beschichtet sind, und nach der Beschichtung, die Platten (3) in einer Nitride enthaltenden Gasatmosphäre behandelt werden, wobei die Nitride aus Amiden gewählt werden, bei einer Temperatur von 850 bis 950 °C, um die Härte und Verschleißfestigkeit der Tantaloberfläche auf eine Oberflächenhärte von > 600 HV zu erhöhen.

2. Verfahren zum Herstellen eines Plattenwärmetauschers nach Anspruch 1, **dadurch gekennzeichnet, dass** die Platten (3) mit aus Amiden gewählten Nitriden bei einer Temperatur von 900 °C behandelt werden.

3. Verfahren zum Herstellen eines Plattenwärmetauschers nach Anspruch 1 oder 2, **dadurch gekennzeichnet, dass** die Nitride aus Amiden gewählt werden wie beispielsweise Urea, Acetamid und Formamid.

4. Verfahren zum Herstellen eines Plattenwärmetauschers nach Anspruch 1, **dadurch gekennzeichnet, dass** die Beschichtung eine Oberflächenhärte von > 1000 HV besitzt.

5. Plattenwärmetauscher, hergestellt nach dem Verfahren nach einem der Ansprüche 1 bis 4.

## Revendications

1. Procédé de production d'un échangeur de chaleur à plaques (1), comprenant plusieurs plaques d'échangeur de chaleur (3), dans lequel les plaques de l'échangeur de chaleur (3) sont agencées de manière adjacente les unes aux autres et forment un ensemble de plaques (2) avec des premiers espaces intermédiaires des plaques (16) pour un premier milieu et des deuxièmes espaces intermédiaires des plaques (17) pour un deuxième milieu, chacune des plaques de l'échangeur de chaleur comprenant :
des ouvertures (15) formant des orifices (8, 9, 10, 11) s'étendant à travers l'ensemble de plaques (2) ;
une zone de transfert de chaleur (12) ;
une zone de bordure (13) s'étendant vers l'extérieur de la zone de transfert de chaleur (12) et des orifices (8, 9, 10, 11) ;
une rainure de garniture d'étanchéité (19) s'étendant dans la zone de bordure (13) à l'extérieur de la zone de transfert de chaleur (12) et des orifices (8, 9, 10, 11) ;
et dans lequel une garniture d'étanchéité (18) est agencée dans la rainure de garniture d'étanchéité (19) de sorte à buter fermement contre une plaque adjacente (3) dans l'échangeur de chaleur à plaques (1), **caractérisé en ce que** :
les plaques de l'échangeur de chaleur (3) sont au moins partiellement revêtues d'un composé à base de tantale, et après ledit revêtement, les plaques (3) sont traitées dans une atmosphère de gaz contenant des nitrures choisis parmi des amides à une température comprise entre 850 et 950°C en vue d'accroître la dureté et la résistance à l'usure de la surface de tantale à une dureté de surface supérieure à 600 HV.

2. Procédé de production d'un échangeur de chaleur à plaques selon la revendication 1, **caractérisé en ce que** les plaques (3) sont traitées par des nitrures choisis parmi des amides à une température de 900°C.

3. Procédé de production d'un échangeur de chaleur à plaques selon les revendications 1 ou 2, **caractérisé en ce que** les nitrures sont choisis parmi des amides, tels que l'urée, l'acétamide et la formamide.

4. Procédé de production d'un échangeur de chaleur à plaques selon la revendication 1, **caractérisé en ce que** le revêtement a une dureté de surface supérieure à 1000 HV.

5. Echangeur de chaleur à plaques produit par le procédé selon l'une quelconque des revendications 1 à 4.
